# FASCICULE DE BREVET EUROPEEN

(11) **EP 2 951 833 B1**
(45) Date de publication et mention de la délivrance du brevet: **22.09.2021**
(21) Numéro de dépôt: 14702536.5
(22) Date de dépôt: 30.01.2014
(51) Int. Cl.: G11C 13/00, G11C 14/00, H03K 19/177

(54) **PROCEDE DE PROGRAMMATION D'UN DISPOSITIF MEMOIRE RESISTIF A COMMUTATION BIPOLAIRE**
PROGRAMMIERUNG VON BIPOLAREM WIDERSTANDSSPEICHER
PROGRAMMING OF A BIPOLAR RESISTIVE MEMORY CELL

(30) Priorité: 30.01.2013 FR 1350796
(43) Date de publication de la demande: 09.12.2015
(73) Titulaire: Commissariat à l'Énergie Atomique et aux Énergies Alternatives, 75015 Paris (FR)
(72) Inventeur: ONKARAIAH, Santhosh, 9500 Villach (AT); BELLEVILLE, Marc, F-38120 Saint Egreve (FR); CLERMIDY, Fabien, F-38120 Saint-Egreve (FR)
(74) Mandataire: Brevalex
(86) Numéro de dépôt international: PCT/EP2014/051753
(87) Numéro de publication internationale: WO 2014/118255

(56) Documents cités:
- US-A1- 2007 041 242
- US-A1- 2007 146 012
- US-A1- 2011 235 393
- US-A1- 2012 063 201
- US-A1- 2012 243 297

## Description

### DOMAINE TECHNIQUE

L'invention concerne un procédé de programmation d'au moins un dispositif mémoire à commutation bipolaire, par exemple de type CBRAM ou RRAM, ainsi qu'un procédé de programmation d'une cellule mémoire différentielle comprenant au moins deux dispositifs mémoires à commutation bipolaire. L'invention concerne également un circuit électronique comprenant au moins un dispositif mémoire à commutation bipolaire et permettant de programmer le dispositif mémoire.

### ÉTAT DE LA TECHNIQUE ANTÉRIEURE

Il existe plusieurs types de mémoires non-volatiles, comme par exemple des mémoires magnétiques (MRAM, STTRAM), des mémoires à matériaux à changement de phases (PCRAM), ou encore des mémoires résistives (CBRAM, RRRAM ou ReRAM, OxReRAM). Ces mémoires peuvent mémoriser au moins deux états différents de manière non-volatile. Ces mémoires sont soient unipolaires, c'est-à-dire peuvent être programmées dans l'un ou l'autre des deux états mémoires en appliquant des tensions, ou courants, d'écriture de valeurs différentes mais de même polarité, soient bipolaires, c'est-à-dire peuvent être programmées dans l'un ou l'autre des deux états mémoires en appliquant des tensions, ou courants, d'écriture de polarités opposées comme par exemple en faisant circuler dans la mémoire des courants de sens opposés.

Dans un élément mémoire de type résistif, le passage d'un premier état mémoire à un deuxième état mémoire correspond à un changement abrupte entre un état à forte résistivité (HRS pour « High-Resistance State », ou état OFF) et un état à faible résistivité (LRS pour « Low-Resistance State », ou état ON). Un tel élément mémoire de type résistif bipolaire comporte un empilement d'une électrode active formée sur un électrolyte solide lui-même formé sur une électrode inerte. L'électrolyte solide, qui est par exemple composé de chalcogénure, d'oxyde, de nitrure, de carbure ou encore de silicium amorphe, sert de matériau mémoire. L'électrode active est composée de métal tel que de l'argent ou du cuivre et est apte à délivrer des ions par exemple de type Ag⁺ ou Cu²⁺ afin de former des filaments conducteurs entre les deux électrodes lorsque l'élément mémoire est à l'état ON. L'électrode inerte est par exemple composée de métal tel que du tungstène ou du platine.

Lorsqu'une tension positive est appliquée entre l'électrode active et l'électrode inerte (potentiel électrique positif sur l'électrode active et potentiel électrique nul sur l'électrode inerte), l'électrode active s'oxyde et des ions métalliques (par exemple de type Ag⁺ ou Cu²⁺ selon la nature du métal de l'électrode active) sont délivrés par l'électrode active dans l'électrolyte vers l'électrode inerte pour former des filaments conducteurs reliant électriquement les deux électrodes. La croissance de ces filaments conducteurs entre les deux électrodes permet à l'élément mémoire de passer de l'état OFF à l'état ON.

Lorsqu'une tension négative est appliquée entre l'électrode active et l'électrode inerte (potentiel électrique négatif sur l'électrode active et potentiel électrique nul sur l'électrode inerte), les filaments conducteurs sont alors dissous, permettant ainsi à l'élément mémoire de passer de l'état ON à l'état OFF.

De tels dispositifs mémoires à programmation bipolaire ont donc pour inconvénients de nécessiter l'application d'une tension négative aux bornes des électrodes du dispositif mémoire, via l'application d'un potentiel électrique négatif sur l'électrode active, pour réaliser la programmation d'un des états mémoires (état OFF).

Lorsqu'il n'est pas possible de faire appel à un potentiel électrique négatif pour programmer cet état OFF, il est dans ce cas nécessaire de pouvoir commuter le signal de données des deux côtés du dispositif mémoire, c'est-à-dire sur l'électrode active ou sur l'électrode inerte selon l'état mémoire à programmer, avec dans ce cas un signal de données correspondant à un potentiel électrique positif pour signifier un état 1 et à un potentiel électrique nul pour signifier un état 0. Toutefois, cela implique la réalisation de circuits de commutation et de routage complexes, comme par exemple décrit dans les documents US 2010/110765 A1 et US 2007/132049 A1. Le document US 2007/0146012 décrit un circuit électronique selon le préambule de la revendication 1. Chacun des documents US 2007/0041242 et US 2012/0243297 décrit un procédé de programmation d'un dispositif mémoire à commutation bipolaire. Chacun des documents US 2011/0235393 et US 2012/0063201 divulgue des moyens de contrôle de grille d'un transistor d'accès, permettant le passage d'un courant à travers le transistor d'accès après l'application des tensions de programmation.

### EXPOSÉ DE L'INVENTION

La présente invention propose un circuit électronique selon la revendication 1.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un circuit électronique selon un premier mode de réalisation comportant un dispositif mémoire non volatile à commutation bipolaire destiné à être programmé par la mise en œuvre d'un procédé de programmation,
- les figures 2 et 3 sont des chronogrammes de signaux d'un dispositif mémoire selon le premier mode de réalisation, obtenus lors de la mise en œuvre d'un procédé programmation,
- la figure 4 représente un circuit électronique selon un deuxième mode de réalisation, qui est un mode de réalisation de l'invention, comportant deux dispositifs mémoires non volatiles à commutation bipolaire destinés à être programmés de manière complémentaire par la mise en œuvre d'un procédé de programmation,
- les figures 5 et 6 sont des chronogrammes de signaux d'un circuit électronique selon le deuxième mode de réalisation, obtenus lors de la mise en œuvre d'un procédé programmation de deux dispositifs mémoires,
- la figure 7 représente un circuit électronique selon un troisième mode de réalisation, qui est un aussi un mode de réalisation de l'invention, comportant plusieurs dispositifs mémoires non volatiles à commutation bipolaire destinés à être programmés de manière complémentaire deux à deux par la mise en œuvre d'un procédé de programmation,
- la figure 8 représente un circuit électronique selon un quatrième mode de réalisation, comportant plusieurs dispositifs mémoires non volatiles à commutation bipolaire destinés à être programmés par la mise en œuvre d'un procédé de programmation,
- la figure 9 est un exemple de chronogramme de signaux appliqués en entrée du circuit électronique selon le quatrième mode de réalisation de lors de la mise en œuvre d'un procédé de programmation,
- la figure 10 représente un circuit électronique selon une variante du quatrième mode de réalisation,
- la figure 11 représente un circuit électronique selon un cinquième mode de réalisation comportant plusieurs dispositifs mémoires non volatiles à commutation bipolaire destinés à être programmés par la mise en œuvre d'un procédé de programmation,
- la figure 12 est un exemple de chronogramme de signaux appliqués en entrée du circuit électronique selon le cinquième mode de réalisation lors de la mise en œuvre d'un procédé de programmation,
- la figure 13 représente un circuit électronique selon un sixième mode de réalisation comportant plusieurs dispositifs mémoires non volatiles à commutation bipolaire destinés à être programmés par la mise en œuvre d'un procédé de programmation,
- la figure 14 est un exemple de chronogramme de signaux appliqués en entrée du circuit électronique selon le sixième mode de réalisation lors de la mise en œuvre d'un procédé de programmation.
Les modes de réalisation des fig.1 à 3 et 8 à 14 ne relèvent pas de l'invention et ne sont présents qu'à titre illustratif.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (modes de réalisation de l'invention et variantes associées) doivent être comprises comme n'étant pas exclusives les unes des autres et peuvent se combiner entre elles.

### EXPOSÉ DÉTAILLÉ DE MODES DE RÉALISATION PARTICULIERS

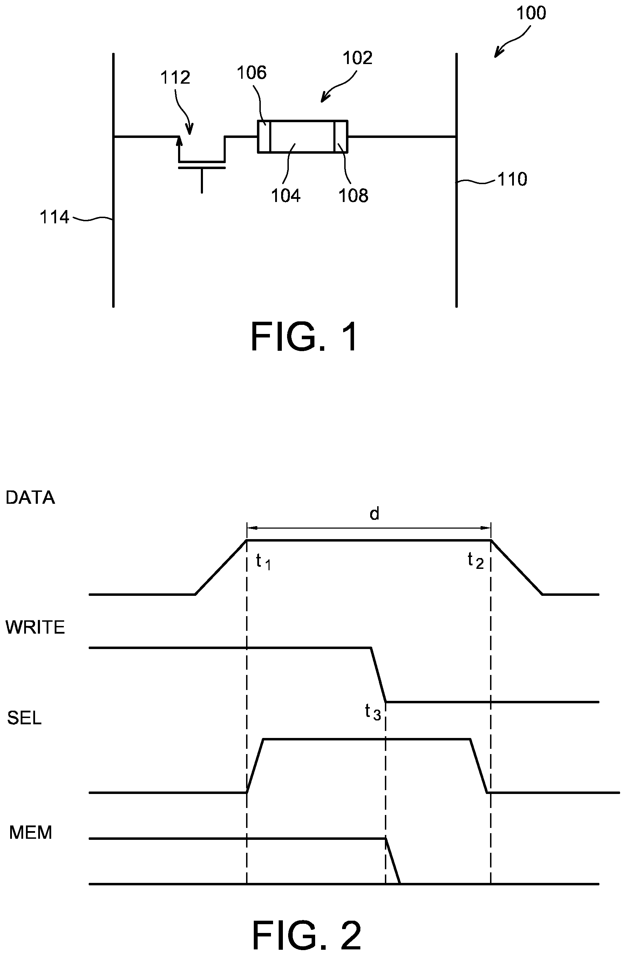

On se réfère tout d'abord à la figure 1 qui représente un circuit électronique 100 selon un premier mode de réalisation, comportant un dispositif mémoire non volatile 102 à commutation bipolaire destiné à être programmé par la mise en œuvre d'un exemple de procédé de programmation.

Dans l'exemple de réalisation décrit ici, le dispositif mémoire 102 est de type ReRAM et comporte un électrolyte solide 104 de type résistif disposé entre une électrode active 106 et une électrode inerte 108. L'électrode active 106 et l'électrode inerte 108 forment les bornes du dispositif mémoire 102 sur lesquelles une tension de programmation du dispositif mémoire 102 est destinée à être appliquée.

L'électrode inerte 108 est reliée électriquement à une première ligne électriquement conductrice 110 sur laquelle un signal de commande (« WRITE ») est destiné à être appliqué. L'électrode active 106 est reliée électriquement au drain d'un transistor 112 de type MOS, correspondant à un transistor de sélection du dispositif mémoire 102. Dans l'exemple de réalisation décrit ici, le transistor 112 est de type NMOS. Dans une variante de réalisation, le transistor 112 pourrait être de type PMOS, ou être remplacé par une porte CMOS comportant un transistor NMOS relié en parallèle à un transistor PMOS. La source du transistor 112 est reliée électriquement à une deuxième ligne électriquement conductrice 114 sur laquelle un signal de données (« DATA ») est destiné à être appliqué. Un signal de sélection (« SEL ») est destiné à être appliqué sur la grille du transistor 112 (le signal de sélection est adapté selon que le transistor 112 soit de type NMOS ou PMOS, ou corresponde à une porte CMOS). Le transistor de sélection 112 permet de relier électriquement l'électrode active 106 du dispositif mémoire 102 à la deuxième ligne électriquement conductrice 114 lorsqu'une programmation du dispositif mémoire 102 doit être réalisée. De plus, lorsque le transistor de sélection 112 est passant, il permet également d'imposer une limitation du courant circulant à travers le dispositif mémoire 102. Ainsi, la deuxième ligne électriquement conductrice 114 correspond à des premiers moyens aptes à appliquer, sur l'électrode active 106 du dispositif mémoire 102, le signal de données, et la première ligne électriquement conductrice 110 forme des deuxièmes moyens aptes à appliquer, sur l'électrode inerte 108 du dispositif mémoire 102, le signal de commande.

Les signaux DATA, SEL et WRITE correspondent ici à des potentiels électriques aptes à prendre deux valeurs correspondant respectivement à des états 0 et 1. Les valeurs des potentiels électriques correspondant aux états binaires 0 et 1 des signaux DATA et WRITE dépendent notamment des caractéristiques et de la technologie de réalisation du dispositif mémoire 102. Les potentiels électriques correspondant à un même état 0 ou 1 sont similaires ou sensiblement similaires pour les deux signaux DATA et WRITE. Dans l'exemple décrit ici, l'état 0 des signaux DATA et WRITE correspond par exemple à un potentiel électrique nul, tandis que l'état 1 de ces signaux correspond par exemple à un potentiel électrique positif dont la valeur dépend des matériaux utilisés : pour un dispositif mémoire de type OxReRam à base d'oxyde d'Hafnium, la tension de programmation est par exemple égale à environ 0,5 V (valeur variant en fonction de l'épaisseur de l'oxyde d'Hafnium), tandis que pour un dispositif mémoire de type CBRAM, la tension de programmation peut être comprise entre environ 0,2 V et 1,5 V. De même, les valeurs des potentiels électriques correspondant respectivement aux états binaires 0 et 1 du signal SEL dépendent notamment des caractéristiques et de la technologie de réalisation du transistor 112. Dans l'exemple décrit ici, la tension de programmation du dispositif mémoire 102, c'est-à-dire la différence de potentiels appliquée aux bornes du dispositif mémoires 102, est égale à environ 0,5 V.

Dans l'exemple décrit ici, l'état 0 du signal SEL correspond par exemple à un potentiel électrique nul, tandis que l'état 1 de ce signal correspond par exemple à un potentiel électrique supérieur à la tension de seuil du transistor afin que celui-ci soit conducteur.

L'état mémoire programmé dans le dispositif mémoire 102 est appelé MEM et correspond soit à un état à forte résistivité HRS, appelé état haut et représenté sur les chronogrammes comme une valeur binaire égale à 1, et un état à faible résistivité LRS, appelé état bas et représenté sur les chronogrammes comme une valeur binaire égale à 0. Ainsi, le dispositif mémoire 102 est programmé à l'état bas lorsque le signal DATA est à l'état 1 et que le signal WRITE est à l'état 0, et le dispositif mémoire 102 est programmé à l'état haut lorsque le signal DATA est à l'état 0 et que le signal WRITE est à l'état 1.

Bien que non représentés, le circuit électronique 100 comporte d'autres dispositifs mémoires comprenant leurs bornes reliées électriquement à la première ligne électriquement conductrice 110 et à la deuxième ligne électriquement conductrice 114 via un transistor de sélection par exemple similaire au transistor 112. La programmation a alors lieu dans les dispositifs mémoires pour lesquels le transistor de sélection est à l'état passant.

On décrit maintenant, en liaison avec le chronogramme représenté sur la figure 2, une programmation à l'état bas du dispositif mémoire 102 du circuit électronique 100 précédemment décrit, pouvant être assimilée à une mémorisation d'une valeur binaire 0 dans le dispositif mémoire 102 du circuit électronique 100.

Lors d'une programmation du dispositif mémoire 102, aussi bien pour une programmation à l'état bas qu'à l'état haut, le signal SEL passe à l'état 1 afin que le transistor de sélection 112 soit à l'état passant et que l'électrode active 106 se retrouve reliée électriquement à la deuxième ligne électriquement conductrice 114.

Le signal de données DATA, qui est représentatif de la donnée à mémoriser par le dispositif mémoire 102, passe à l'état 1 pendant une durée d, correspondant à une durée allant d'un premier instant t₁ à un deuxième instant t₂ (avec donc d = t₂-t₁) sur l'exemple de la figure 2. Le signal SEL passe à l'état 1 au cours de cette durée d afin d'éviter une éventuelle programmation du dispositif mémoire 102 dans un état autre que celui souhaité, en dehors de cette durée d. Sur la figure 2, on voit donc qu'aux instants t₁ et t₂ le signal SEL est à l'état 0, et passe à l'état 1 juste après t₁ et repasse à l'état 0 juste avant t₂. L'activation du signal SEL se produit donc une fois que le signal DATA est stabilisé à la valeur représentative de la donnée à mémoriser. La durée pendant laquelle le signal SEL est à l'état 1, qui correspond à la durée pendant laquelle un courant peut travers le dispositif mémoire 102, est appelée durée de programmation, cette durée de programmation étant incluse dans la durée d.

De plus, au cours de cette durée d, entre les instants t₁ et t₂, le signal de commande WRITE passe de l'état 1 à l'état 0. Un instant t₃, inclus entre t₁ et t₂, correspond à l'instant auquel le signal de commande WRITE passe de l'état 1 à l'état 0.

Ainsi, pendant une première partie de la durée d allant de t₁ à environ t₃ (environ car le passage de l'état 1 à l'état 0 du signal WRITE n'est pas instantané), des signaux à l'état 1 sont appliqués sur chacune des deux électrodes 106 et 108 du dispositif mémoire 102. Un même potentiel électrique se retrouve donc appliqué sur chacune des bornes du dispositif mémoire 102, ce qui est équivalent à l'application d'une tension nulle aux bornes du dispositif mémoire 102. Un état mémoire MEM initial du dispositif mémoire 102 ne change donc pas au cours de cette première partie de la durée d et reste à l'état bas ou haut selon l'état mémoire initial du dispositif mémoire 102.

A partir de l'instant t₃, le signal de commande WRITE est à l'état 0. Du fait que le signal de données DATA est toujours à l'état 1, le dispositif mémoire 102 voit donc à ses bornes une tension d'environ 0,5 V, c'est-à-dire ici un potentiel électrique positif de 0,5 V appliqué sur l'électrode active 106 et un potentiel électrique nul appliqué sur l'électrode inerte 108. L'état mémoire MEM du dispositif mémoire 102 passe alors à l'état bas à l'instant t₃ si l'état mémoire initial correspond à l'état haut, ou reste à l'état bas si celui-ci correspond à l'état mémoire initial.

A partir de l'instant t₂, le signal de données DATA repasse à l'état 0. Du fait que le signal de commande WRITE est toujours à l'état 0, un même potentiel électrique se retrouve donc appliqué sur les deux bornes 106, 108 du dispositif mémoire 102, ce qui est équivalent à l'application d'aucune tension (ou d'une tension nulle) aux bornes du dispositif mémoire 102. L'état mémoire MEM du dispositif mémoire 102 ne change donc pas et reste à l'état bas. Le signal SEL repasse à 0 avant que le signal de données DATA et/ou le signal de commande WRITE changent de valeur et ne soient susceptibles de modifier l'état mémoire MEM du dispositif mémoire 102.

Il est possible de faire passer le signal SEL à l'état 0 dès que l'information souhaitée est mémorisée dans le dispositif mémoire 102, c'est-à-dire ici pendant la seconde partie de la durée d allant de t₃ à t₂. Dans le cas présent, il serait possible que le signal SEL passe de l'état 1 à l'état 0 après t₂, sous la condition que les signaux DATA et WRITE restent tous les deux à l'état 0 après t₂ afin de ne pas modifier l'état de programmation du dispositif mémoire 102. Toutefois, il est préférable que le signal SEL repasse à l'état 0 lorsque le signal DATA est encore dans son état stabilisé.

Dans l'exemple décrit ci-dessus en liaison avec la figure 2, c'est donc le passage de l'état 1 à l'état 0 du signal de commande WRITE qui déclenche la mémorisation de l'état bas dans le dispositif mémoire 102.

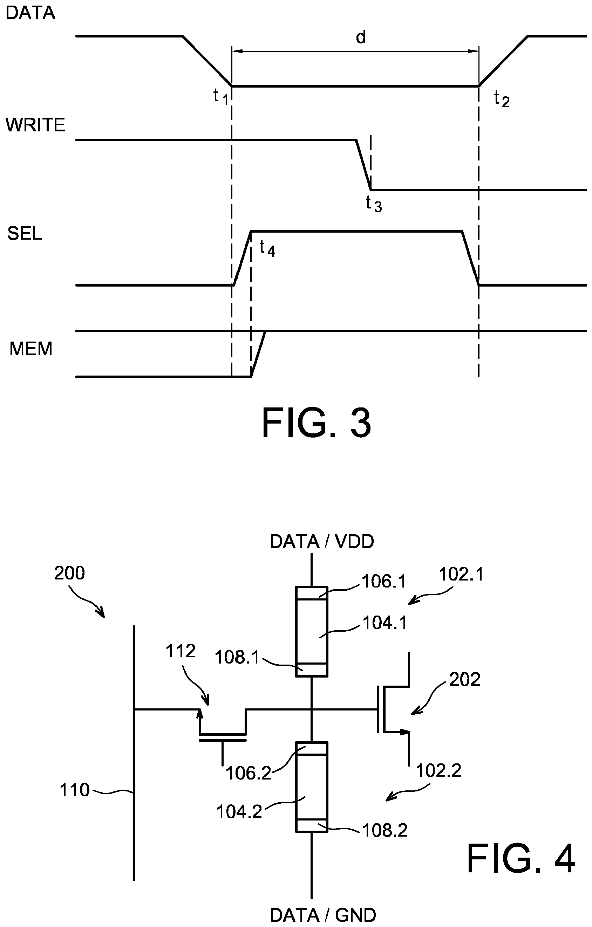

On décrit maintenant, en liaison avec le chronogramme représenté sur la figure 3, une programmation du dispositif mémoire 102 à l'état haut, pouvant être assimilée à une mémorisation d'une valeur binaire 1 dans le dispositif mémoire 102.

Le signal de données DATA passe à l'état 0 pendant une durée d, correspondant à t₂-t₁ sur l'exemple de la figure 3. Le signal SEL passe à l'état 1 à partir de t₁ afin que le transistor 112 soit à l'état passant et que l'électrode active 106 se retrouve reliée électriquement à la deuxième ligne électriquement conductrice 114. Le signal SEL se retrouve à l'état 1 à un instant t4, un peu après t₁.

A l'instant t₄, le signal de données DATA est déjà stabilisé à l'état 0. Du fait que le signal de commande WRITE est à l'état 1 à l'instant t₄, le dispositif mémoire 102 voit donc à ses bornes une tension équivalente à -0,5 V, formée ici par un potentiel électrique positif de 0,5 V appliqué sur l'électrode inerte 108 et un potentiel électrique nul appliqué sur l'électrode active 106. L'état mémoire MEM du dispositif mémoire 102 passe alors à l'état haut à l'instant t₄ ou reste à l'état haut si celui-ci correspond à l'état mémoire initial.

A l'instant t₃, inclus entre t₁ et t₂, le signal de commande WRITE passe de l'état 1 à l'état 0.

Ce changement d'état n'affecte pas l'état mémorisé dans le dispositif mémoire 102 car pendant la seconde partie de la durée d allant de t₃ à t₂, un signal à l'état 0 est appliqué sur chacune des deux électrodes 106 et 108 du dispositif mémoire 102. Un même potentiel électrique se retrouve donc appliqué sur chacune des deux bornes 106, 108 du dispositif mémoire 102, ce qui est équivalent à l'application d'aucune tension ou d'une tension nulle aux bornes du dispositif mémoire 102. L'état mémoire MEM du dispositif mémoire 102 ne change donc pas et reste à l'état haut au cours de cette seconde partie de la durée d.

Le signal SEL repasse à l'état 0 avant que le signal de données DATA ne repasse à l'état 1 car sinon, l'état mémorisé MEM repasserait à l'état bas.

Dans l'exemple décrit ci-dessus en liaison avec la figure 3, c'est donc le passage de l'état 1 à l'état 0 du signal DATA, et le passage à l'état 1 du signal SEL, qui déclenchent la mémorisation de l'état haut dans le dispositif mémoire 102.

On voit donc que dans l'exemple du circuit 100 précédemment décrit, le signal DATA est mémorisé tel qu'un état 0 de ce signal soit mémorisé sous la forme d'un état haut du dispositif mémoire 102, et qu'un état 1 du signal DATA soit mémorisé sous la forme d'un état bas du dispositif mémoire 102.

De plus, comme cela est visible sur les figures 2 et 3, le signal de commande WRITE utilisé pour la programmation à l'état bas du dispositif mémoire 102 est le même que celui utilisé pour la programmation à l'état haut du dispositif mémoire 102. Ainsi, il n'est pas nécessaire d'adapter ce signal de commande WRITE en fonction de l'état dans lequel le dispositif mémoire 102 est destiné à être programmé.

En variante, il est possible que le signal de données DATA soit appliqué sur la première ligne électriquement conductrice 110 et que le signal de commande WRITE soit appliqué sur la deuxième ligne électriquement conductrice 114. Cela est équivalent à inverser la disposition du dispositif mémoire 102 par rapport à la configuration représentée sur la figure 1, c'est-à-dire à relier électriquement l'électrode inerte 108 au drain du transistor de sélection 112 et à relier électriquement l'électrode active 106 à la première ligne de transmission 110. Dans cette variante, l'état mémoire MEM mémorisé dans le dispositif mémoire 102 est tel que le dispositif mémoire 102 est à l'état haut lorsque le signal de données DATA mémorisé est à l'état 1, et est à l'état bas lorsque le signal de données DATA mémorisé est à l'état 0.

Par rapport à la configuration représentée sur la figure 1, il est également possible que le transistor de sélection 112 ne soit pas interposé entre l'électrode active 106 et la deuxième ligne de transmission 114, mais entre l'électrode inerte 108 et la première ligne électriquement conductrice 110, ou que la source du transistor 112 soit reliée électriquement à l'une des bornes du dispositif mémoire 102, ou encore que le circuit électronique 100 ne comporte pas ce transistor de sélection 112.

Dans le procédé de programmation précédemment décrit, l'écriture d'un état mémoire dans le dispositif mémoire 102 est obtenue grâce au fait qu'au cours de la durée d, le signal de commande WRITE passe de l'état 1 à l'état 0. En variante, il est possible que lors d'une programmation du dispositif mémoire 102, c'est-à-dire au cours de la durée d, le signal de commande WRITE passe de l'état 0 à l'état 1. En effet, le procédé de programmation décrit ici permet la programmation du dispositif mémoire 102 dans l'un ou l'autre des deux états haut ou bas du fait qu'au cours de la durée d de programmation du dispositif mémoire 102 pendant laquelle le signal de données DATA est à l'état que l'on souhaite mémoriser (ou dans l'état inverse de celui qui sera mémorisé), le signal de commande WRITE passe par les deux états 1 et 0, et cela quelque soit l'ordre dans lequel ces deux états sont atteints par le signal WRITE. Dans ce cas, le signal de commande WRITE utilisé pour la programmation à l'état bas du dispositif mémoire 102 est également le même que celui utilisé pour la programmation à l'état haut du dispositif mémoire 102.

Dans les exemples de programmation précédemment décrits, au cours de la durée d, le signal WRITE ne change d'état qu'une seule fois. Toutefois, il est également possible de prévoir qu'au cours de la durée d, le signal WRITE passe plusieurs fois de l'état 1 à l'état 0 et inversement.

Dans le procédé de programmation précédemment décrit, pendant la période au cours de laquelle le signal de données DATA est à l'état que l'on souhaite mémoriser (c'est-à-dire pendant la période t₂-t₁), le signal de commande WRITE est à l'état 1 pendant une première partie de la durée d correspondant approximativement à la moitié de cette durée d, et est à l'état 0 pendant une deuxième partie de la durée d correspondant approximativement à la moitié de cette durée d (autrement dit, le changement d'état du signal de commande WRITE a lieu approximativement à la moitié de cette durée d). En variante, il est possible que la partie de la durée d au cours de laquelle signal de commande WRITE est à l'état 0 soit plus courte ou plus longue que la partie de la durée d au cours de laquelle signal de commande WRITE est à l'état 1, pendant la phase de programmation du dispositif mémoire 102. Ces durées peuvent notamment être ajustées en fonction des caractéristiques du dispositif mémoire 102 qui ne sont pas toujours symétriques, comme décrit par exemple dans le document « Conductive bridging RAM (CBRAM): an emerging non-volatile memory technology scalable to sub 20nm » de M. Kund et al., Electron Devices Meeting, 2005. IEDM Technical Digest. IEEE International, pages 754 - 757.

La figure 4 représente un circuit électronique 200 selon un deuxième mode de réalisation comportant deux dispositifs mémoires non volatiles 102.1 et 102.2 à commutation bipolaire similaires au dispositif mémoire 102 précédemment décrit et destinés à être programmés de manière complémentaire (c'est-à-dire dans deux états différents) via le procédé de programmation précédemment décrit.

Le circuit électronique 200 comporte une première ligne électriquement conductrice 110 reliée électriquement au drain d'un transistor de sélection 112.

La source du transistor de sélection 112 est reliée électriquement à l'électrode inerte 108.1 du premier dispositif mémoire 102.1 et à l'électrode active 106.2 du deuxième dispositif mémoire 102.2. Le signal de commande WRITE similaire à celui précédemment décrit en liaison avec le premier circuit électronique 100 est appliqué sur la première ligne électriquement conductrice 110. Le signal SEL également similaire à celui précédemment décrit est appliqué sur la grille du transistor de sélection 112. Un premier signal de données DATA/Vdd est appliqué sur l'électrode active 106.1 du premier dispositif mémoire 102.1 via des moyens non représentés sur la figure 4, et un deuxième signal de données DATA/Gnd est appliqué sur l'électrode inerte 108.2 du deuxième dispositif mémoire 102.2.

La source du transistor de sélection 112 ainsi que l'électrode inerte 108.1 du premier dispositif mémoire 102.1 et l'électrode active 106.2 du deuxième dispositif mémoire 102.2 sont reliées électriquement à la grille d'un deuxième transistor 202 dont l'état passant ou bloqué est destiné à être commandé en fonction de la valeur des états mémorisés dans les dispositifs mémoires 102.1 et 102.2.

Lorsque le circuit électronique 200 est en mode « programmation », c'est-à-dire lorsque les états mémorisés par les dispositifs mémoires 102.1 et 102.2 sont programmés, le premier signal de données DATA/Vdd prend alors une valeur similaire à celle du deuxième signal de données DATA/Gnd. Lorsque le circuit électronique 200 est en mode « commande », c'est-à-dire lorsque les dispositifs mémoires 102.1 et 102.2 sont utilisés pour commander la mise à l'état passant ou bloqué du deuxième transistor 202, le premier signal de données DATA/Vdd est à l'état 1 (correspondant au potentiel électrique Vdd) et le deuxième signal de données DATA/Gnd est à l'état 0 (correspondant à un potentiel électrique nul).

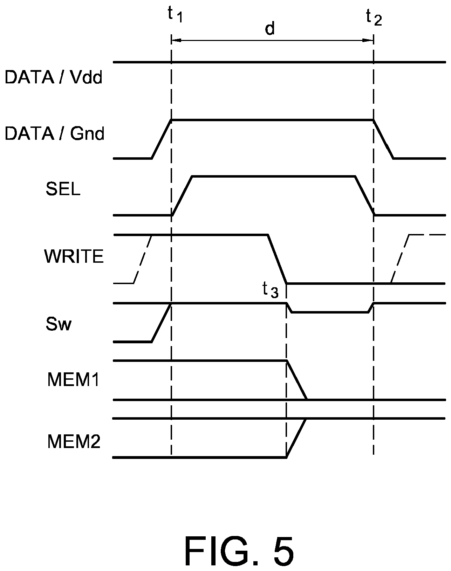

On décrit maintenant, en liaison avec le chronogramme représenté sur la figure 5, une programmation du premier dispositif mémoire 102.1 à l'état bas et du deuxième dispositif mémoire 102.2 à l'état haut.

Le premier signal de données DATA/Vdd étant par défaut (en mode « commande ») à l'état 1, celui-ci est laissé à l'état 1 durant toute la durée du mode « programmation » lorsque le premier dispositif mémoire 102.1 à destiné à être programmé à l'état bas et que le deuxième dispositif mémoire 102.2 est destiné à être programmé à l'état haut. Par contre, du fait que le deuxième signal de données DATA/Gnd est par défaut (en mode « commande ») à l'état 0, celui-ci passe à l'état 1 pendant la durée d de programmation, correspondant à t₂-t₁, du circuit 200.

Comme précédemment décrit, le signal SEL passe à l'état 1 au cours de cette durée d afin que le transistor 112 soit passant et que l'électrode inerte 108.1 du premier dispositif mémoire 102.1 et l'électrode active 106.2 du deuxième dispositif mémoire 102.2 se retrouvent reliées électriquement à la première ligne électriquement conductrice 110 et soumises au potentiel électrique du signal de commande WRITE lors de la phase de programmation de ces dispositifs. Comme cela est visible sur cette figure, la durée de programmation des dispositifs mémoires 102.1 et 102.1, correspondant à la durée pendant laquelle le signal SEL est à l'état 1, est donc incluse dans la durée d. De plus, au cours de cette durée d, le signal de commande WRITE passe de l'état 1 à l'état 0. L'instant t₃, inclus entre t₁ et t₂, correspond à l'instant à partir duquel le signal de commande WRITE se retrouve à l'état 0.

Ainsi, pendant la partie de la durée d allant du passage du signal SEL à l'état 1 jusqu'à t₃, un signal à l'état 1 est appliqué sur chacune des deux électrodes de chacun des dispositifs mémoires 102.1 et 102.2. Un même potentiel électrique se retrouve donc appliqué sur les deux bornes 106, 108 de chacun des dispositifs mémoires 102.1 et 102.2, ce qui est équivalent à l'application d'aucune tension ou d'une tension nulle aux bornes des dispositifs mémoires 102.1 et 102.2. L'état mémoire MEM1 du premier dispositif mémoire 102.1 et l'état mémoire MEM2 du deuxième dispositif mémoire 102.2 ne changent donc pas et restent à leur état initial respectif pendant cette partie de la durée d.

A partir de l'instant t₃, le signal de commande WRITE est à l'état 0. Du fait que les signaux de données DATA/Vdd et DATA/Gnd sont toujours à l'état 1, le premier dispositif mémoire 102.1 voit donc à ses bornes une tension de 0,5 V, c'est-à-dire ici un potentiel électrique positif de 0,5 V appliqué sur son électrode active 106.1 et un potentiel électrique nul appliqué sur son électrode inerte 108.1. L'état mémoire MEM1 du premier dispositif mémoire 102.1 passe alors à l'état bas à l'instant t₃ si l'état mémoire initial correspond à l'état haut, ou reste à l'état bas si celui-ci correspond à l'état mémoire initial MEM1.

Parallèlement, le deuxième dispositif mémoire 102.2 voit à ses bornes une tension équivalente à -0,5 V, c'est-à-dire ici un potentiel électrique positif de 0,5 V appliqué sur son électrode inerte 108.2 et un potentiel électrique nul appliqué sur son électrode active 106.2. L'état mémoire MEM2 du deuxième dispositif mémoire 102.2 passe alors à l'état haut à l'instant t₃ si l'état mémoire initial correspond à l'état bas, ou reste à l'état haut si celui-ci correspond à l'état mémoire initial MEM2.

A partir de l'instant t₂, le circuit électronique 200 sort du mode « programmation » pour revenir dans le mode « commande ». Le premier signal de données DATA/Vdd reste à l'état 1 et le deuxième signal de données DATA/Gnd repasse à l'état 0. Le signal SEL repasse à l'état 0 avant que le signal de données DATA/Gnd et/ou le signal de commande WRITE changent de valeur et ne modifient les états mémorisés dans les dispositifs mémoires 102.1 et 102.2. Le signal SEL repasse donc à l'état 0 entre les instants t₃ et t₂.

Comme précédemment décrit en liaison avec la figure 2, la programmation des dispositifs mémoires 102.1 et 102.2 est déclenchée par le passage de l'état 1 à l'état 0 du signal de commande WRITE au cours de la durée d.

Après l'instant t₂, le circuit électronique 200 est en mode « commande ». Le transistor 202 est alors commandé via les états mémorisés dans les dispositifs mémoires 102.1 et 102.2. En effet, les deux dispositifs mémoires 102.1 et 102.2 sont dans ce cas équivalents à deux résistances électriques dont les valeurs sont fonction de l'état mémorisé et formant un pont diviseur de tension. Le rapport des valeurs des résistances électriques entre un dispositif mémoire à l'état haut (forte résistivité) et un dispositif mémoire à l'état bas (faible résistivité) est supérieur à 10 ou supérieur à 100. Dans l'exemple décrit en liaison avec la figure 5, du fait que le premier dispositif mémoire 102.1 est à l'état bas et que le deuxième dispositif mémoire est à l'état haut, la tension qui se retrouve appliquée sur la grille du transistor 202 est alors suffisante, et de valeur proche de celle de Vdd compte tenu de la faible résistivité du premier dispositif mémoire 102.1 et de la forte résistivité du deuxième dispositif mémoire 102.2, pour rendre le transistor 202 passant (représenté par le signal Sw à l'état 1 sur la figure 5). On voit sur la figure 5 que le signal Sw peut prendre trois valeurs différentes :
- Pendant la durée d, lorsque les signaux WRITE et DATA ont la même valeur, le signal Sw suit alors cette valeur.
- Pendant la durée d, lorsque les signaux WRITE et DATA ont des valeurs opposées (écriture), le signal Sw prend une valeur intermédiaire, fixée par le rapport des courants traversant le transistor de sélection 112 et les deux résistances formées par les dispositifs mémoires 102.1 et 102.2, et les tensions des signaux WRITE, DATA/VDD et DATA/GND.
- Après la durée d, le signal Sw se met à une valeur 1 ou 0, selon la valeur programmée dans les résistances.

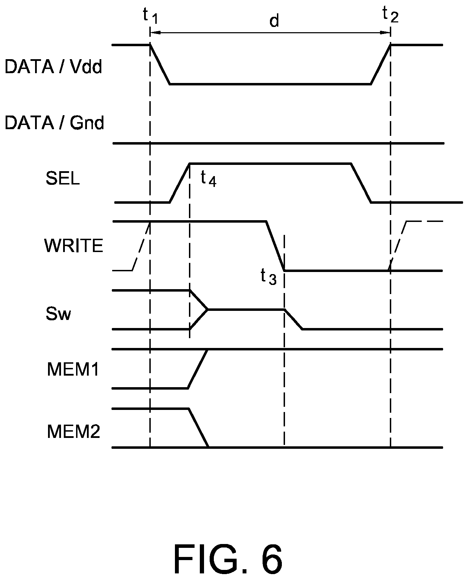

On décrit maintenant, en liaison avec le chronogramme représenté sur la figure 6, une programmation du premier dispositif mémoire 102.1 à l'état haut et du deuxième dispositif mémoire 102.2 à l'état bas.

Le deuxième signal de données DATA/Gnd étant par défaut (en mode « commande ») à l'état 0, celui est laissé à l'état 0 durant toute la durée de programmation lorsque le premier dispositif mémoire 102.1 à destiné à être programmé à l'état haut et que le deuxième dispositif mémoire 102.2 est destiné à être programmé à l'état bas. Par contre, du fait que le premier signal de données DATA/Vdd est par défaut à l'état 1, celui-ci passe à l'état 0 pendant la durée d de programmation. Au cours de cette durée d, le signal SEL passe à l'état 1 afin que le transistor 112 soit passant et que l'électrode inerte 108.1 du premier dispositif mémoire 102.1 et l'électrode active 106.2 du deuxième dispositif mémoire 102.2 soient reliées électriquement à la première ligne électriquement conductrice 110.

Peu après l'instant t₁, le signal SEL est à l'état 1 (à l'instant t₄). Du fait que le signal de commande WRITE est à l'état 1, le premier dispositif mémoire 102.1 voit donc à ses bornes, à partir de l'instant t₄, une tension équivalente à -0,5 V formée par un potentiel électrique positif de 0,5 V appliqué sur l'électrode inerte 108.1 et un potentiel électrique nul appliqué sur l'électrode active 106.1. L'état mémoire MEM1 du premier dispositif mémoire 102.1 passe ou reste à l'état haut à l'instant t₄. Le deuxième dispositif mémoire 102.2 voit à ses bornes une tension de 0,5 V (potentiel électrique positif de 0,5 V appliqué sur l'électrode active 106.2 et potentiel électrique nul appliqué sur l'électrode inerte 108.2). L'état mémoire MEM2 du deuxième dispositif mémoire 102.2 passe ou reste à l'état bas à l'instant t₄.

A l'instant t₃, inclus entre t₁ et t₂, le signal de commande WRITE passe de l'état 1 à l'état 0. Ce changement d'état n'affecte pas les états mémorisés dans les dispositifs mémoires 102.1 et 102.2 (équivalent à l'application d'une tension sensiblement nulle aux bornes de chacun des dispositifs mémoires 102.1 et 102.2). Le signal SEL repasse ensuite à l'état 0 avant que le signal de données DATA ne repasse à l'état 1, c'est-à-dire avant t₂.

Dans l'exemple décrit ci-dessus, c'est donc le passage de l'état 1 à l'état 0 du signal de données DATA et le passage du signal SEL à l'état 1 qui déclenche la mémorisation de l'état haut dans le premier dispositif mémoire 102.1 et de l'état bas dans le deuxième dispositif mémoire 102.2.

Comme cela est visible sur les figures 5 et 6, le signal de commande WRITE utilisé pour la programmation à l'état bas du premier dispositif mémoire 102.1 et à l'état haut du deuxième dispositif mémoire 102.2 est le même que celui utilisé pour la programmation à l'état haut du premier dispositif mémoire 102.1 et à l'état bas du deuxième dispositif mémoire 102.2.

Après t₂, le circuit électronique 200 est en mode « commande ». Le transistor 202 est alors commandé par les états mémorisés dans les dispositifs mémoires 102.1 et 102.2. Dans l'exemple décrit en liaison avec la figure 6, du fait que le premier dispositif mémoire 102.1 est à l'état haut et que le deuxième dispositif mémoire est à l'état bas, la tension qui se retrouve appliquée sur la grille du transistor 202 est alors proche d'une tension nulle, bloquant le transistor 202 (représenté par le signal Sw à l'état 0 sur la figure 6).

Dans le circuit électronique 200 précédemment décrit, la durée pour qu'un des dispositifs mémoires 102.1 ou 102.2 passe de l'état haut à l'état bas est inférieure à la durée pour que l'autre dispositif mémoire passe de l'état bas à l'état haut (sur les figures 5 et 6, ces durées soient représentées comme étant équivalentes pour des raisons de simplification). Ainsi, cela évite que le circuit électronique 200 se retrouve dans un état transitoire indésirable dans lequel les deux dispositifs mémoires 102.1 et 102.2 seraient à l'état bas simultanément.

En variante, il est possible que le câblage du circuit électronique 200 soit modifié tel que l'électrode active 106.1 du premier dispositif mémoire 102.1 et l'électrode inerte 108.2 du deuxième dispositif mémoire 102.2 soient reliées électriquement à la source du transistor de sélection 112, et que les signaux DATA/Vdd et DATA/Gnd soient destinés à être appliqués respectivement sur l'électrode inerte 108.1 du premier dispositif mémoire 102.1 et sur l'électrode active 106.2 du deuxième dispositif mémoire 102.2. Dans ce cas, pour les mêmes signaux DATA/Vdd, DATA/Gnd, SEL et WRITE que ceux précédemment décrits en liaison avec les figures 5 et 6, les états mémorisés dans les dispositifs mémoires 102.1 et 102.2 seraient inversés par rapport à ceux précédemment décrits en liaison avec ces figures.

En variante, il est également possible que lors de la phase de programmation des dispositifs mémoires 102.1 et 102.2, c'est-à-dire au cours de la durée d, le signal de commande WRITE passe de l'état 0 à l'état 1. Il est également possible que la partie de la durée d au cours de laquelle le signal de commande WRITE est à l'état 0 soit plus courte ou plus longue que celle au cours de laquelle le signal de commande WRITE est à l'état 1.

Dans une autre variante, il est également possible que les deux électrodes inertes 108.1 et 108.2 (ou les deux électrodes actives 106.1 et 106.2) des deux dispositifs mémoires 102.1 et 102.2 soient reliées électriquement à la source du transistor 112. Dans ce cas, lorsque le circuit 200 est en mode programmation, le premier signal de données DATA/Vdd appliqué sur l'électrode active 106.1 (ou l'électrode inerte 108.1) du premier dispositif mémoire 102.1 est de valeur inverse du deuxième signal de données DATA/Gnd appliqué sur l'électrode active 106.2 (l'électrode inerte 108.2) du deuxième dispositif mémoire 102.2.

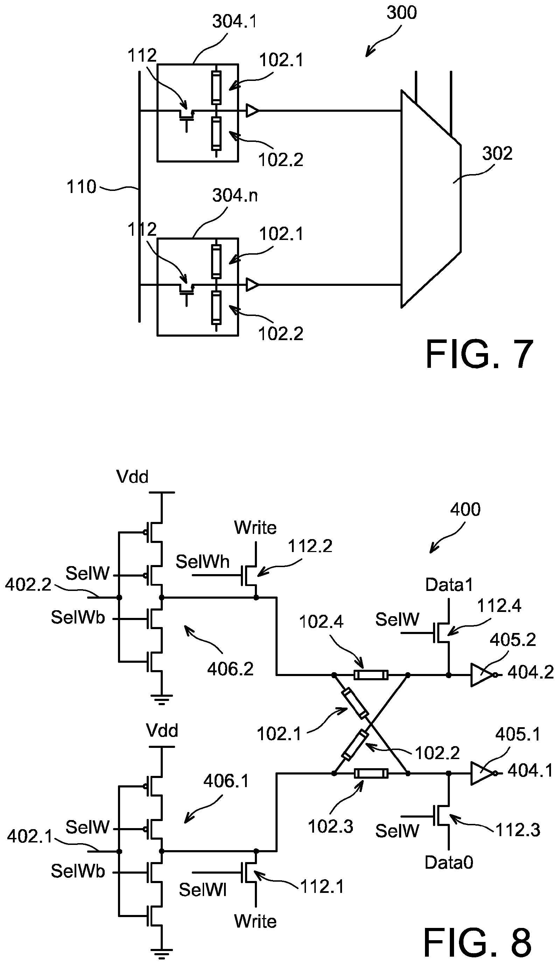

La figure 7 représente un autre circuit électronique 300 selon un troisième mode de réalisation faisant appel à des dispositifs mémoires non-volatiles bipolaires programmés deux à deux de manière complémentaire comme précédemment décrit pour le circuit électronique 200. Le circuit électronique 300 est ici une table de correspondance (ou LUT pour Look-Up Table) de type FPGA comportant un multiplexeur à n bits 302, avec n nombre entier supérieur à 1. Chacune des n entrées du multiplexeur 302 est reliée à un des éléments mémoires 304.1 à 304.n chacun formé de deux dispositifs mémoires 102.1 et 102.2, similaires à ceux précédemment décrits, programmés de manière complémentaire, et d'un transistor de sélection 112. Ainsi, le multiplexeur 302 peut délivrer en sortie les valeurs mémorisées dans les éléments mémoires 304.1 à 304.n, et donc dans les dispositifs mémoires 102.1 et 102.2 de ces éléments mémoires, en fonction de signaux de commande, ou signaux d'adressage, appliqués en entrée du multiplexeur 302.

La figure 8 représente un autre circuit électronique 400 selon un quatrième mode de réalisation correspondant à un système d'interconnexions programmables. Ce circuit 400 comporte notamment deux entrées 402.1, 402.2, deux sorties 404.1, 404.2 correspondant aux sorties de deux inverseurs 405.1 et 405.2, et quatre dispositifs mémoires non-volatiles bipolaires 102.1 à 102.4. Le circuit 400 est apte à délivrer sur l'une et/ou l'autre des deux sorties 404.1, 404.2 les valeurs des signaux appliqués sur l'une et/ou l'autre des deux entrées 402.1, 402.2 selon l'état haut ou bas de chacun des quatre dispositifs mémoires 102.1 - 102.4.

Les états 0 et 1 que peuvent prendre les sorties 404.1 et 404.2 peuvent correspondre respectivement à une tension de référence nulle et une tension V_{DD} par exemple égale à 0,5 V.

La programmation de chacun des quatre dispositifs mémoires 102.1 - 102.4 est réalisée de manière analogue à celle précédemment décrite en liaison avec les figures 1 à 3. Le signal de commande WRITE est destiné à être appliqué sur les électrodes inertes du premier et du deuxième dispositifs mémoires 102.1 et 102.2 lorsqu'un premier transistor de sélection 112.1 est passant, l'état passant ou bloqué de ce premier transistor de sélection 112.1 étant commandé via un signal SELWL appliqué sur la grille de ce transistor 112.1. Ce même signal de commande WRITE est également destiné à être appliqué sur les électrodes inertes du troisième et du quatrième dispositif mémoire 102.3, 102.4 lorsqu'un deuxième transistor de sélection 112.2 est passant, l'état passant ou bloqué de ce deuxième transistor de sélection 112.2 étant commandé via un signal SELWH appliqué sur la grille de ce transistor 112.2. Un premier signal de données DATA0 est destiné à être appliqué sur les électrodes actives du premier et du troisième dispositif mémoire 102.1, 102.3 lorsqu'un troisième transistor de sélection 112.3 est passant, l'état passant ou bloqué de ce troisième transistor de sélection 112.2 étant commandé via un signal SELW appliqué sur la grille de ce transistor 112.3. Un deuxième signal de données DATA1 est destiné à être appliqué sur l'électrode active 106.2 du deuxième et du quatrième dispositif mémoire 102.2, 102.4 lorsqu'un quatrième transistor de sélection 112.4 est passant, l'état passant ou bloqué de ce quatrième transistor de sélection 112.4 étant commandé via le signal SELW appliqué sur la grille de ce transistor 112.4.

Le premier dispositif mémoire 102.1 et le troisième dispositif mémoire 102.3 sont programmés de manière complémentaire afin d'éviter d'interconnecter simultanément les deux entrées 402.1 et 402.2 sur la seule sortie 404.1. De même, le deuxième dispositif mémoire 102.2 et le quatrième dispositif mémoire 102.4 sont programmés de manière complémentaire afin d'éviter d'interconnecter simultanément les deux entrées 402.1 et 402.2 sur la sortie 404.2.

La première entrée 402.1 est reliée à l'entrée d'une première porte à 3 états (ou « tri-state ») 406.1, formée par deux transistors PMOS et deux transistors NMOS et recevant également en entrée le signal SELW et un autre signal SELWB qui est complémentaire du signal SELW (c'est-à-dire sera à l'état 1 lorsque SELW sera à l'état 0, et inversement).

De même, la deuxième entrée 402.2 est reliée à l'entrée d'une deuxième porte à 3 états 406.2 recevant également en entrée les signaux SELW et SELWB.

Le circuit 400 est en mode commutation (par opposition au mode programmation dans lequel on définit les états mémoires des dispositifs mémoires 102.1 - 102.4), dans lequel il commute les entrées 402.1, 402.2 vers les sorties souhaitées 404.1, 404.2, lorsque le signal SELW est à l'état 0, que le signal SELWB est l'état 1, et que les signaux SELWL et SELWH sont à l'état 0. Dans ce cas, l'état 0 ou 1 appliqué sur la première entrée 402.1 se retrouve sur les électrodes inertes du premier et du deuxième dispositif mémoire 102.1, 102.2, et l'état 0 ou 1 appliqué sur la deuxième entrée 402.2 se retrouve sur les électrodes inertes du troisième et du quatrième dispositif mémoire 102.3, 102.4. Selon les états mémoires programmés dans les dispositifs mémoires 102.1 - 102.4, les états 0 ou 1 de l'une et/ou l'autre des entrées 402.1 et 402.2 se retrouvent sur l'une et/ou l'autre des sorties 404.1, 404.2.

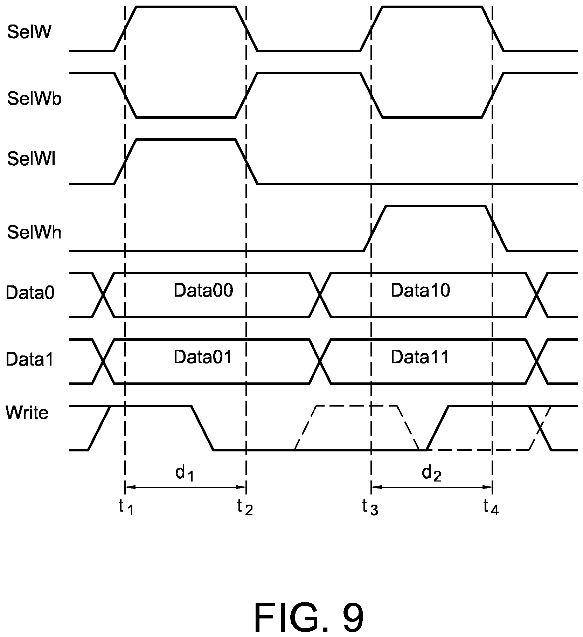

On décrit, en liaison avec le chronogramme de la figure 9, un exemple de programmation des dispositifs mémoires 102.1 - 102.4. Du fait que deux signaux de données sont utilisés pour programmer les quatre dispositifs mémoires 102.1 - 102.4, les dispositifs mémoires 102.1 - 102.4 sont programmés deux par deux en deux phases distinctes, ici les dispositifs mémoires 102.1 et 102.2 au cours d'une première phase de programmation et les dispositifs mémoires 102.3 et 102.4 au cours d'une deuxième phase de programmation.

Cette programmation des dispositifs mémoires en deux phases distinctes permet également d'éviter de court-circuiter les deux entrées 402.1, 402.2 entre elles.

Pendant une première phase de programmation comprise entre t₁ et t₂, correspondant à une durée d₁, le signal SELW passe à l'état 1 et le signal SELWB passe à l'état 0, faisant ainsi passer le circuit 400 en mode programmation. Le signal SELWL passe à l'état 1 et le signal SELWH est à l'état 0, ce qui implique que seuls les deux dispositifs mémoires 102.1 et 102.2 seront programmés (du fait que l'état 1 de SELWL rend le premier transistor de sélection 112.1 passant et que l'état 0 de SELWH bloque le deuxième transistor de sélection 112.2). Au cours de cette première phase, le signal de commande WRITE passe de l'état 1 à l'état 0, ce qui provoque la mémorisation de l'état du signal de données DATA0 dans le premier dispositif mémoire 102.1 et la mémorisation de l'état du signal de données DATA1 dans le deuxième dispositif mémoire 102.2.

Pendant la période allant de t₂ à t₃, le signal SELW passe à l'état 0 et le signal SELWB passe à l'état 1, faisant ainsi passer le circuit 400 en mode commutation. Les états des entrées 402.1, 402.2 sont alors routés vers les sorties 404.1, 404.2 en fonction des états de mémorisation des dispositifs mémoires 102.1 - 102.4. Au cours de cette période, les signaux SELWL et SELWH sont à l'état 0 afin d'éviter que le signal de commande WRITE ne vienne perturber le routage des signaux d'entrées.

Pendant une deuxième phase de programmation comprise entre t₃ et t₄, correspondant à une durée d₂, le signal SELW repasse à l'état 1 et le signal SELWB repasse à l'état 0, faisant ainsi passer le circuit 400 en mode programmation. Le signal SELWL reste à l'état 1 et le signal SELWH passe à l'état 1, ce qui implique que seuls les deux dispositifs mémoires 102.3 et 102.4 seront programmés (du fait que l'état 1 de SELWH rend le deuxième transistor de sélection 112.2 passant et que l'état 0 de SELWL bloque le premier transistor de sélection 112.1). Au cours de cette deuxième phase de programmation, le signal de commande WRITE passe de l'état 0 à l'état 1, ce qui provoque la mémorisation de l'état du signal de données DATA0 dans le troisième dispositif mémoire 102.3 et la mémorisation de l'état du signal de données DATA1 dans le quatrième dispositif mémoire 102.4.

En variante, il est possible, avant d'engager cette deuxième phase de programmation, de refaire passer le signal de commande WRITE de l'état 0 à l'état 1 afin que lors de la deuxième phase de programmation, la mémorisation dans les dispositifs mémoire soit déclenchée par le passage de l'état 1 à l'état 0 du signal de commande WRITE. Cette variante demande toutefois une énergie supplémentaire par rapport au cas précédent. Dans tous les cas, il est possible que le signal de commande WRITE soit similaire durant les différentes phases de programmation, est cela quelque soient les valeurs des états dans lesquels les dispositifs mémoires sont destinés à être programmés (cas du signal WRITE représenté en pointillés pendant la durée d2 qui correspond au signal WRITE représenté en trait plein pendant la durée d1).

Les différentes variantes envisagées dans les circuits électroniques précédemment décrits peuvent également s'appliquer au circuit électronique 400.

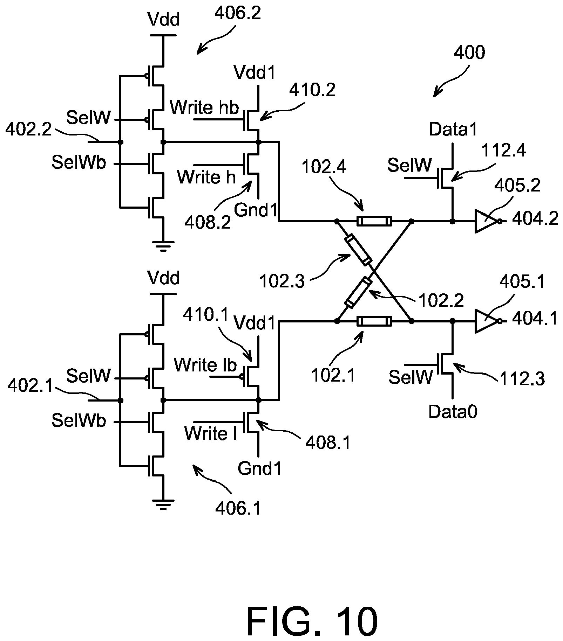

Une variante de réalisation du circuit électronique 400 est représentée sur la figure 10.

Par rapport au circuit 400 de la figure 8, les transistors de sélection 112.1 et 112.2 sont chacun remplacés par deux transistors complémentaires PMOS et NMOS référencés 408.1, 410.1, 408.2 et 410.2 qui, en fonction des états de quatre signaux WRITEL, WRITELB, WRITEH et WRITEHB (avec WRITELB complémentaire de WRITEL, et WRITEHB complémentaire de WRITEH), appliquent un potentiel V_{DD1} ou un potentiel de référence nul Gnd1 sur les électrodes inertes des dispositifs mémoires 102.1-102.4.

Cette variante de réalisation permet de dissocier clairement les tensions de fonctionnement et les tensions de programmation, ce qui permet d'éviter, en fonctionnement normal (transmission des signaux de l'entrée vers la sortie), de modifier l'état des résistances. Des tensions inférieures au seuil de programmation des résistances sont dans ce cas utilisées.

Pour diminuer la consommation énergétique de certains circuits intégrés, des interrupteurs de puissance sont utilisés pour couper l'alimentation de blocs non utilisés dans ces circuits intégrés. Il est parfois utile d'utiliser des bascules de rétention pour sauvegarder, durant cette coupure, tout ou partie de l'état interne du bloc. Une bascule est constituée de deux dispositifs de verrouillage, ou latchs, reliés en série : l'un de type maître et l'autre de type esclave. Dans une bascule à rétention, une partie du dispositif de verrouillage esclave garde l'information et est capable de la restituer lorsque l'alimentation est rétablie. Il est par exemple possible d'utiliser une alimentation permanente dans une partie du dispositif de verrouillage esclave. Pour supprimer cette alimentation permanente, il est possible d'utiliser dans le dispositif de verrouillage esclave (ou le maitre) des dispositifs mémoires résistifs, comme décrit par exemple dans le document de W. Zhao et al., « Spin-MTJ based Non-Volatile Flip-Flop », Proceedings of the 7th IEEE International Conférence on Nanotechnology, August 2 - 5, 2007, Hong Kong.

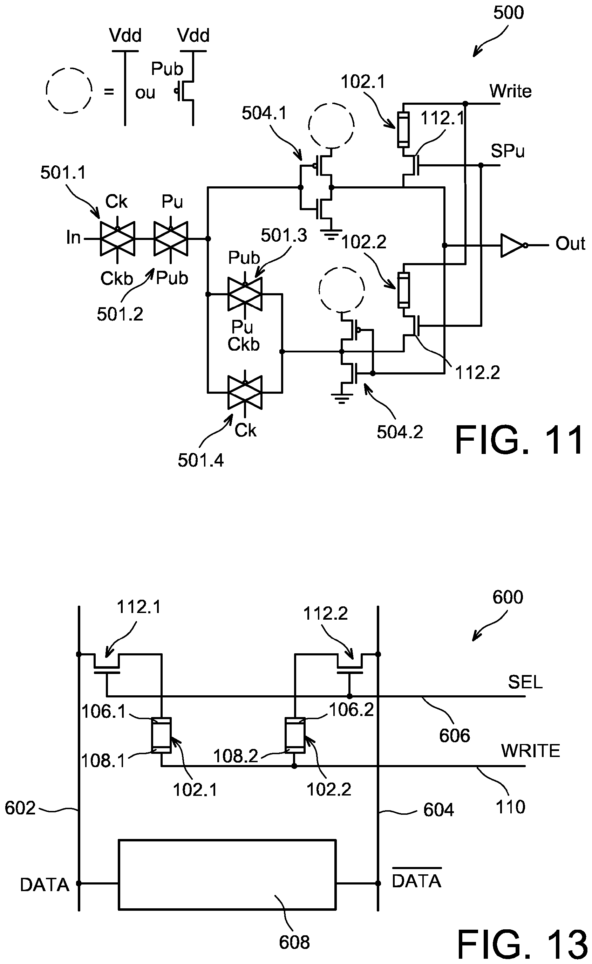

Des dispositifs mémoires non-volatiles bipolaires programmés via un procédé analogue à celui précédemment décrit peuvent avantageusement être utilisés pour réaliser de tels dispositifs de verrouillage. Ainsi, la figure 11 représente un circuit électronique 500 selon un cinquième mode de comportant des dispositifs mémoires non-volatiles bipolaires programmés de manière analogue aux dispositifs mémoires précédemment décrits. Ce circuit électronique 500 représente le dispositif de verrouillage esclave d'une bascule à rétention utilisant deux dispositifs résistifs à mémoire bipolaires 102.1 et 102.2 qui sont programmés de manière analogue à celle précédemment décrite.

Les deux dispositifs mémoires 102.1 et 102.2 ont ici la même orientation, c'est-à-dire comportent chacun leur électrode active reliée électriquement à une entrée commune sur laquelle est appliqué un signal de commande WRITE.

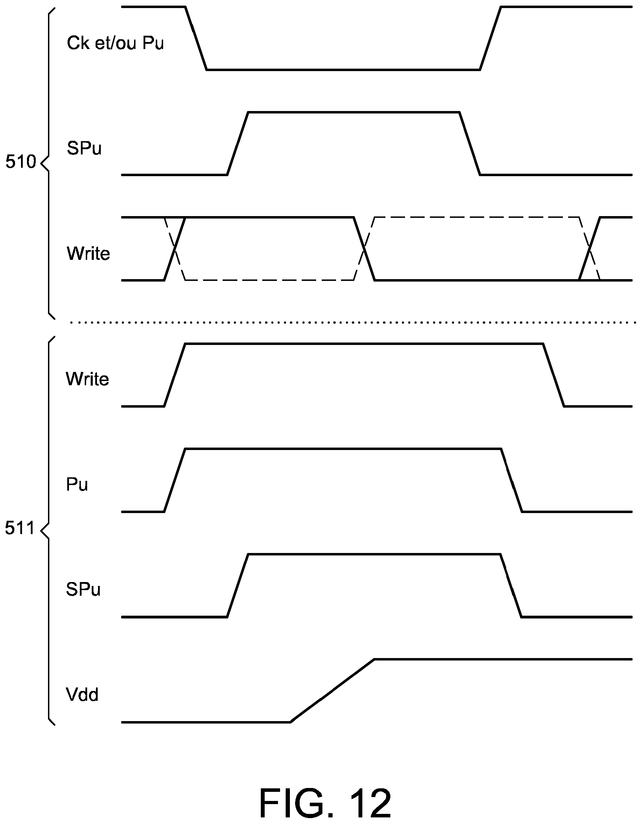

Le dispositif 500 comporte une entrée « In » et quatre portes de transmission CMOS 501.1 à 501.4 commandées par des signaux Ck et Pu (et leurs signaux complémentaires Ckb et Pub) et une sortie « Out ». L'état interne du dispositif 500, correspondant aux sorties de deux inverseurs CMOS 504.1 et 504.2 dont les entrées sont reliées aux portes de transmission CMOS 501.2 à 501.4, est recopié dans les deux dispositifs mémoires 102.1 et 102.2 en rendant conducteurs deux transistors d'accès 112.1 et 112.2 via un signal de sélection SPu appliqué sur leurs grilles (les électrodes inertes des dispositifs mémoires 102.1 et 102.2 sont reliées aux drains des transistors 112.1 et 112.2 respectivement), puis en effectuant une transition (passage de l'état 0 à l'état 1, ou passage de l'état 1 à l'état 0) sur le signal WRITE. Un des deux dispositifs mémoires 102.1, 102.2 est programmé pendant l'état 1 du signal WRITE, et l'autre est programmé pendant l'état 0 du signal WRITE. Les signaux 510 représentés sur la figure 12 correspondent aux signaux Ck, Pu, SPu et WRITE lors de cette phase de programmation des dispositifs mémoires 102.1 et 102.2.

Après une phase de coupure de l'alimentation, les deux dispositifs mémoires 102.1 et 102.2 sont utilisés pour réinitialiser dans l'état de départ les nœuds internes du dispositif 500, au niveau des sorties des inverseurs CMOS 504.1 et 504.2.

Avant la remise sous tension, le signal Pu est activé (mi à l'état 1) pour reboucler le dispositif 500 et le déconnecter du dispositif de verrouillage maitre auquel est couplé le dispositif de verrouillage esclave 500. Les dispositifs mémoires 102.1 et 102.2 sont reliés aux nœuds internes en activant le signal SPu (mis à l'état 1). Le signal WRITE passe à l'état 1 (liaison à Vdd). Lors de la remise sous tension, les résistances des dispositifs mémoires 102.1 et 102.2 (l'un à l'état haut et l'autre à l'état bas) créent un déséquilibre qui va forcer le dispositif de verrouillage esclave 500 dans son état initial. La programmation complémentaire des dispositifs mémoires 102.1 et 102.2 permet de réinitialiser correctement le dispositif de verrouillage esclave 500 à la remise sous tension, et cela naturellement du fait que les deux nœuds internes du circuit sont toujours dans des états opposés (car séparés par un inverseur).

Pour faciliter cette réinitialisation, il peut être utile de déconnecter les transistors PMOS des inverseurs CMOS 504.1 et 504.2 rebouclés du dispositif 500 pendant cette remise sous tension. Dans ce cas, les cercles représentés en pointillés correspondent chacun à un transistor MOS permettant d'appliquer ou non la tension Vdd aux inverseurs CMOS 504.1 et 504.2. Les signaux 512 représentés sur la figure 12 correspondent aux signaux WRITE, Pu, SPu et vdd lors de cette phase de remise sous tension du dispositif de verrouillage esclave 500.

La figure 13 représente un circuit électronique 600 selon un sixième mode de réalisation formant une cellule différentielle de type RRAM et comportant des dispositifs mémoires non-volatiles bipolaires programmés de manière analogue aux dispositifs mémoires précédemment décrits. Une telle cellule est notamment destinée à former l'une des multiples cellules mémoires d'un circuit mémoire.

Le circuit 600 comporte un premier dispositif mémoire 102.1 dont l'électrode inerte 108.1 est reliée à une première ligne électriquement conductrice 110 (qui pourrait être disposée en colonne et reliée à d'autres dispositifs mémoires) sur laquelle est appliqué un signal de commande WRITE et dont l'électrode active 106.1 est reliée à la source d'un premier transistor d'accès 112.1, et comporte également un deuxième dispositif mémoire 102.2 dont l'électrode inerte 108.2 est reliée également à la première ligne électriquement conductrice 110 et dont l'électrode active 106.2 est reliée à la source d'un deuxième transistor d'accès 112.2. Le drain du premier transistor d'accès 112.1 est relié à une deuxième ligne électriquement conductrice 602 sur laquelle est appliqué un premier signal de données DATA et le drain du deuxième transistor d'accès 112.2 est relié à une troisième ligne électriquement conductrice 604 sur laquelle est appliqué un deuxième signal de données /DATA dont l'état est complémentaire de celui du premier signal de données DATA. Les lignes électriquement conductrices 602 et 604 sont orientées en colonne afin de pouvoir être reliées à d'autres cellules mémoire. Les grilles des deux transistors 112.1 et 112.2 sont reliées à une quatrième ligne électriquement conductrice 606 sur laquelle est appliqué un signal de sélection SEL. Dans la cellule mémoire différentielle 600, les deux dispositifs mémoires 102.1 et 102.2 sont destinés à être programmés de manière complémentaire.

La quatrième ligne électriquement conductrice 606 correspond à une ligne de sélection de mot. Les transistors d'accès permettent, outre l'accès aux dispositifs mémoires 102.1 et 102.2 lors d'une programmation de ces dispositifs, de limiter le courant traversant ces dispositifs mémoires 102.1 et 102.2.

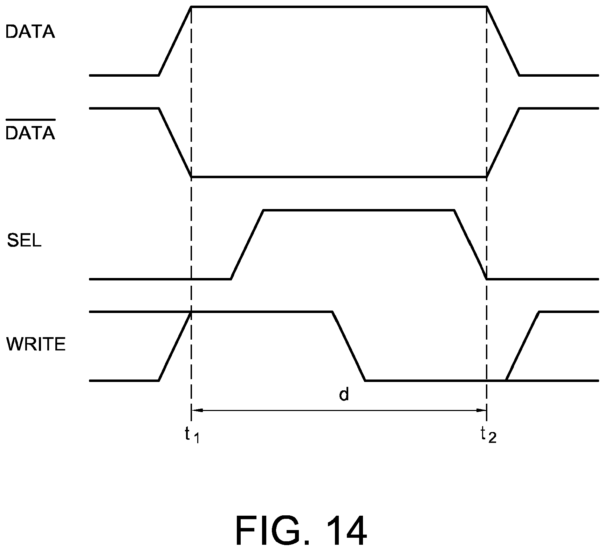

La figure 14 représente un chronogramme des signaux du circuit 600 lors d'une programmation des dispositifs mémoires 102.1 et 102.2. Pendant la période allant de t₁ à t₂, correspondant à une durée d, le premier signal de données DATA passe à l'état 1 et le deuxième signal de données /DATA passe à l'état 0. Le signal de commande WRITE passe également à l'état 1 à peu près à l'instant t₁ (ou reste à l'état 1). Entre t₁ et t₂, le signal SEL passe à l'état 1, rendant ainsi passant les transistors d'accès 112.1 et 112.2, et provoquant ainsi le passage du deuxième dispositif mémoire 102.2 à l'état haut. Puis, le signal de commande WRITE passe à l'état 0, provoquant le passage du premier dispositif mémoire 102.1 à l'état bas. Un peu avant l'instant t₂, le signal SEL repasse à l'état 0. Les signaux de données DATA et /DATA peuvent alors changer d'état sans modifier l'état mémoire des dispositifs mémoires 102.1 et 102.2. Les variantes de programmation précédemment décrites peuvent d'appliquer à la programmation des dispositifs mémoires 102.1, 102.2 de ce circuit 600.

Une telle cellule mémoire différentielle peut être couplée à une ou plusieurs cellules mémoires de type SRAM 608 programmées via les mêmes signaux de données DATA et /DATA.

En variante, il est possible que l'électrode inerte de l'un des dispositifs mémoires 102.1, 102.2 soit reliée à la source du transistor d'accès correspondant, et que l'électrode active de ce dispositif mémoire soit alors reliée à la première ligne électriquement conductrice 110. Dans ce cas, lors de la programmation des dispositifs mémoires 102.1 et 102.2, un même signal de données transite sur les lignes électriquement conductrices 602 et 604. Les deux dispositifs mémoires 102.1 et 102.2 sont alors programmés au cours d'une même partie de la durée d (lorsque le signal WRITE est à l'état 0 ou 1). Toutefois, du fait que la durée de programmation de l'état haut à l'état bas est inférieure à la durée de programmation de l'état bas à l'état haut, cela évite que le circuit 600 se retrouve dans un état transitoire indésirable dans lequel les deux dispositifs mémoires 102.1 et 102.2 seraient à l'état bas simultanément.

Les circuits électroniques 100 à 600 sont généralement réalisés en grand nombre au sein de circuits de type FPGA, dans lesquels les signaux utilisés sont mutualisés entre l'ensemble des circuits électroniques.

## Revendications

1. Circuit électronique (200) comprenant un premier dispositif mémoire (102.1) à commutation bipolaire comportant une première électrode (106.1) et une deuxième électrode (108.1) aux bornes desquelles une tension de programmation apte à programmer le premier dispositif mémoire (102.1) dans un état à forte résistivité ou à faible résistivité est destinée à être appliquée, le circuit électronique (200) comportant :
- un dispositif de sélection (112) relié électriquement au premier dispositif mémoire (102.1) et comprenant un premier transistor ayant une première électrode de source ou de drain connectée à la deuxième électrode (108.1) du premier dispositif mémoire (102.1), ce premier transistor étant un transistor MOS ;
- un deuxième dispositif mémoire (102.2) apte à être programmé dans un état complémentaire de celui dans lequel le premier dispositif mémoire (102.1) est destiné à être programmé, dans lequel la deuxième électrode (108.1) du premier dispositif mémoire (102.1) est reliée électriquement à l'une d'une première électrode (106.2) et d'une deuxième électrode (108.2) du deuxième dispositif mémoire (102.2),
dans lequel les premier et deuxième dispositifs mémoires (102.1, 102.2) forment un pont diviseur de tension dans lequel une tension de sortie est obtenue sur la deuxième électrode (108.1) du premier dispositif mémoire (102, 102.1), le circuit électronique comportant en outre un deuxième transistor MOS (202) dont l'état passant ou bloqué est fonction des états complémentaires du premier dispositif mémoire (102.1) et du deuxième dispositif mémoire (102.2) et dont la grille de contrôle est reliée électriquement à la deuxième électrode du premier dispositif mémoire (102.1);
le circuit électronique (200) étant **caractérisé en ce qu'**il comporte
- des premiers moyens (114) aptes à appliquer, sur la première électrode (106.1) du premier dispositif mémoire (102.1), un signal de données présentant, pendant une durée d, un état constant 0 ou 1 représentatif de l'état dans lequel le premier dispositif mémoire (102.1) est destiné à être programmé,
- des deuxièmes moyens (110) aptes à appliquer, sur une deuxième électrode de drain ou de source du premier transistor, un signal de commande présentant, au cours de la durée d, au moins une alternance d'un état 1 et d'un état 0, ce signal de commande étant similaire lors d'une programmation du premier dispositif mémoire (102.1) dans un état à forte résistivité ou dans un état à faible résistivité,
dans lequel les états 0 et 1 du signal de données et du signal de commande correspondent à des potentiels électriques respectivement nuls et positifs aptes à former la tension de programmation lorsque l'un du signal de données et du signal de commande est à l'état 0 et que l'autre du signal de données et du signal de commande est à l'état 1,
le circuit électronique (200) comportant en outre des moyens de contrôle de la grille du premier transistor configurés pour, lors d'un cycle d'écriture, permettre, uniquement pendant une durée de programmation strictement incluse dans la durée d, le passage d'un courant à travers le premier transistor afin d'appliquer aux bornes des première et deuxième électrodes (106.1, 108.1) du premier dispositif mémoire (102.1) la tension de programmation,
le passage de l'un des états 0 et 1 du signal de commande à l'autre des états 0 et 1 du signal de commande étant destiné à être commandé pendant ladite durée de programmation,
et comportant en outre des troisièmes moyens aptes à appliquer un deuxième signal de données, sur l'autre de la première électrode (106.2) et de la deuxième électrode (108.2) du deuxième dispositif mémoire (102.2).

2. Circuit électronique (200) selon la revendication 1, dans lequel les premier et deuxième dispositifs mémoires (102, 102.1, 102.2) sont de type CBRAM ou RRAM, les premières électrodes (106, 106.1, 106.2) et les deuxièmes électrodes (108, 108.1, 108.2) des premier et deuxième dispositifs mémoires (102, 102.1, 102.2) correspondant respectivement à des électrodes actives et des électrodes inertes des premier et deuxième dispositifs mémoires (102, 102.1, 102.2), ou inversement.

3. Circuit électronique (200) selon l'une des revendications précédentes, dans lequel le signal de commande est à l'état 1 pendant une première partie de la durée d et est à l'état 0 pendant une second partie de la durée d, la première partie de la durée d correspondant à une durée plus courte ou plus longue que celle de la deuxième partie de la durée d.

4. Circuit électronique (200) selon l'une des revendications précédentes, dans lequel le signal de commande présente, au cours de la durée d, plusieurs alternances entre les états 1 et 0.

5. Circuit électronique (200) selon l'une des revendications précédentes, dans lequel les deuxièmes moyens comportent une première ligne électriquement conductrice (110) reliée électriquement à la deuxième électrode du premier transistor (112).

6. Circuit mémoire comprenant plusieurs circuits électroniques (200) selon l'une des revendications précédentes, dans lequel les deuxièmes moyens (114, 110) de chaque circuit électronique (200) sont communs à plusieurs circuits électroniques (200).

## Patentansprüche

1. Elektronische Schaltung (200), umfassend eine erste Speichervorrichtung (102.1) mit bipolarer Umschaltung, umfassend eine erste Elektrode (106.1) und eine zweite Elektrode (108.1), an deren Anschlüssen eine Programmierspannung, die dazu ausgelegt ist, die erste Speichervorrichtung (102.1) in einen Zustand mit hohem Widerstand oder mit niedrigem Widerstand zu programmieren, angelegt werden kann, wobei die elektronische Schaltung (200) umfasst:
- eine Selektionsvorrichtung (112), die elektrisch mit der ersten Speichervorrichtung (102.1) verbunden ist, und einen ersten Transistor umfasst, der eine erste Source- oder Drain-Elektrode hat, die mit der zweiten Elektrode (108.1) der ersten Speichervorrichtung (102.1) verbunden ist, wobei dieser erste Transistor ein MOS-Transistor ist;
- eine zweite Speichervorrichtung (102.2), die dazu ausgelegt ist, in einen Zustand komplementär zu jenem programmiert zu sein, in den die erste Speichervorrichtung (102.1) programmiert werden kann, wobei die zweite Elektrode (108.1) der ersten Speichervorrichtung (102.1) elektrisch mit einer von einer ersten Elektrode (106.2) und einer zweite Elektrode (108.2) der zweiten Speichervorrichtung (102.2) verbunden ist,
wobei die erste und die zweite Speichervorrichtung (102.1, 102.2) eine Spannungsteilerbrücke bilden, bei der eine Ausgangsspannung an der zweiten Elektrode (108.1) der ersten Speichervorrichtung (102, 102.1) erhalten wird, wobei die elektronische Schaltung ferner einen zweiten MOS-Transistor (202) umfasst, dessen Durchlass- oder Sperrzustand eine Funktion der komplementären Zustände der ersten Speichervorrichtung (102.1) und der zweiten Speichervorrichtung (102.2) ist, und dessen Steuergate elektrisch mit der zweiten Elektrode der ersten Speichervorrichtung (102.1) verbunden ist;
wobei die elektronische Schaltung (200) **dadurch gekennzeichnet ist, dass** sie umfasst:
- erste Mittel (114), die dazu ausgelegt sind, an die erste Elektrode (106.1) der ersten Speichervorrichtung (102.1) ein Datensignal anzulegen, das während einer Dauer d einen konstanten Zustand 0 oder 1 aufweist, der für den Zustand repräsentativ ist, in den die erste Speichervorrichtung (102.1) programmiert werden kann,
- zweite Mittel (110), die dazu ausgelegt sind, an eine zweite Drain- oder Sourceelektrode des ersten Transistors ein Steuersignal anzulegen, das im Verlauf der Dauer d wenigstens eine Alternierung eines Zustands 1 und eines Zustands 0 aufweist, wobei dieses Steuersignal während einer Programmierung der ersten Speichervorrichtung (102.1) in einem Zustand mit hohem Widerstand oder in einem Zustand mit niedrigem Widerstand ähnlich ist,
wobei die Zustände 0 und 1 des Datensignals und des Steuersignals elektrischen Potenzialen von Null beziehungsweise positiv entsprechen, die dazu ausgelegt sind, die Programmierspannung zu bilden, wenn eines von dem Datensignal und dem Steuersignal im Zustand 0 ist und das andere von dem Datensignal und dem Steuersignal im Zustand 1 ist,
wobei die elektronische Schaltung (200) ferner Mittel zur Steuerung des Gates des ersten Transistors umfasst, die dazu konfiguriert sind, während eines Schreibzyklus ausschließlich während einer Programmierdauer, die streng in der Dauer d enthalten ist, den Durchlass eines Stroms durch den ersten Transistor hindurch zu erlauben, um an die Anschlüsse der ersten und der zweiten Elektrode (106.1, 108.1) der ersten Speichervorrichtung (102.1) die Programmierspannung anzulegen,
wobei der Übergang von einem der Zustände 0 und 1 des Steuersignals in den anderen der Zustände 0 und 1 des Steuersignals dazu ausgelegt ist, während der Programmierdauer gesteuert zu werden,
und ferner umfassend dritte Mittel, die dazu ausgelegt sind, ein zweites Datensignal an die andere von der ersten Elektrode (106.2) und der zweiten Elektrode (108.2) der zweiten Speichervorrichtung (102.2) anzulegen.

2. Elektronische Schaltung (200) nach Anspruch 1, bei der die erste und die zweite Speichervorrichtung (102, 102.1, 102.2) vom Typ CBRAM oder RRAM sind, wobei die ersten Elektroden (106, 106.1, 106.2) und die zweiten Elektroden (108, 108.1, 108.2) der ersten und der zweiten Speichervorrichtung (102, 102.1, 102.2) aktiven Elektroden beziehungsweise inerten Elektroden der ersten und der zweiten Speichervorrichtung (102, 102.1, 102.2) entsprechen, oder umgekehrt.

3. Elektronische Schaltung (200) nach einem der vorhergehenden Ansprüche, bei der das Steuersignal während eines ersten Teils der Dauer d im Zustand 1 ist und während eines zweiten Teils der Dauer d im Zustand 0 ist, wobei der erste Teil der Dauer d einer kürzeren oder längeren Dauer entspricht als jene des zweiten Teils der Dauer d.

4. Elektronische Schaltung (200) nach einem der vorhergehenden Ansprüche, bei der das Steuersignal im Verlauf der Dauer d mehrere Alternierungen zwischen den Zuständen 1 und 0 aufweist.

5. Elektronische Schaltung (200) nach einem der vorhergehenden Ansprüche, bei der die zweiten Mittel eine erste elektrisch leitfähige Leitung (110) umfassen, die elektrisch mit der zweiten Elektrode des ersten Transistors (112) verbunden ist.

6. Speicherschaltung, umfassend mehrere elektronische Schaltungen (200) nach einem der vorhergehenden Ansprüche, bei der die zweiten Mittel (114, 110) von jeder elektronischen Schaltung (200) mehreren elektronischen Schaltungen (200) gemeinsam sind.

## Claims

1. Electronic circuit (200) comprising a first bipolar switching memory device (102.1) comprising first (106.1) and second (108.1) electrodes at the terminals of which a programming voltage capable of programming the first memory device (102.1) in a high-resistance or low-resistance state is intended to be applied, the electronic circuit (200) comprising:
- a selection device (112) electrically linked to the first memory device (102.1) and comprising a first transistor having a first source or drain electrode connected to the second electrode (108.1) of the first memory device (102.1), this first transistor being a MOS transistor;
- a second memory device (102.2) able to be programmed in a complementary state to that in which the first memory device (102.1) is intended to be programmed, wherein the second electrode (108.1) of the first memory device (102.1) is electrically linked to one of a first electrode (106.2) and second electrode (108.2) of the second memory device (102.2), wherein the first and second memory devices (102.1, 102.2) form a voltage divider bridge wherein an output voltage is obtained on the second electrode (108.1) of the first memory device (102, 102.1), the electronic circuit further comprising a second MOS transistor (202) an ON or OFF state of which depends on the complementary states of the first memory device (102.1) and the second memory device (102.2) and the control gate of which is electrically connected to the second electrode of the first memory device (102.1);
the electronic circuit (200) being **characterized in that** it comprises
- first means (114) capable of applying, to the first electrode (106.1) of the first memory device (102.1), a data signal having, during a time period d, a constant state 0 or 1, representative of the state in which the first memory device (102.1) is intended to be programmed,
- second means (110) capable of applying, on a second source or drain electrode of the first transistor, a control signal that alternates at least once, during time period d, between a state 1 and a state 0, said control signal being similar when programming the first memory device (102.1) in a high-resistance state or low-resistance state,
wherein the states 0 and 1 of the data signal and of the control signal correspond to zero and positive electric potentials respectively, capable of forming the programming voltage when one of either the data signal or control signal is in state 0 and the other of either the data signal or control signal is in state 1,
the electronic circuit (200) further comprising first transistor gate control means configured for, during a write cycle, allowing a current to flow through the first transistor only during a programming time strictly included in the time period d in order to apply the programming voltage on the first and second electrodes (106.1, 108.1) of the first memory device (102.1).
the change from one of the states 0 or 1 of the control signal to the other of the states 0 or 1 of the control signal being intended to be controlled during said programming time,
and further comprising third means capable of applying a second data signal to the other of the first electrode (106.2) and second electrode (108.2) of the second memory device (102.2).

2. Electronic circuit (200) according to claim 1, wherein the first and second memory devices (102, 102.1, 102.2) are CBRAM or RRAM-type devices, the first (106, 106.1, 106.2) and second (108, 108.1, 108.2) electrodes of the first and second memory devices (102, 102.1, 102.2) respectively corresponding to active electrodes and inert electrodes of the first and second memory devices (102, 102.1, 102.2), or vice-versa.

3. Electronic circuit (200) according to one of the previous claims, wherein the control signal is in state 1 during a first part of the time period d and in state 0 during a second part of the time period d, the first part of the time period d corresponding to a shorter or longer duration than that of the second part of the time period d.

4. Electronic circuit (200) according to one of the previous claims, wherein the control signal alternates multiple times between states 1 and 0 during the time period d.

5. Electronic circuit (200) according to one of the previous claims, wherein the second means include a first electrically conductive line (110) electrically linked to the second electrode of the first transistor (112).

6. Memory circuit comprising several electronic circuits (200) according to one of the previous claims, wherein the second means (114, 110) of each electronic circuit (200) are common to several electronic circuits (200).
